# EUROPEAN PATENT SPECIFICATION

(11) **EP 1 226 285 B1**
(45) Date of publication and mention of the grant of the patent: **22.12.2004**
(21) Application number: 00947291.1
(22) Date of filing: 12.07.2000
(51) Int. Cl.: C22C 27/04, F42B 12/72, C30B 25/10, C30B 25/00

(54) **SINGLE CRYSTAL TUNGSTEN ALLOY PENETRATOR AND METHOD OF MAKING**
EINKRISTALL AUS WOLFRAMLEGIERUNG FÜR PENETRATOR UND HERSTELLUNGSVERFAHREN DAFÜR
MUNITION PENETRANTE EN ALLIAGE DE TUNGSTENE MONOCRISTALLIN ET PROCEDE DE FABRICATION

(30) Priority: 13.07.1999 US 143827 P
(43) Date of publication of application: 31.07.2002
(73) Proprietor: GENERAL ATOMICS, San Diego, California 92121 (US)
(72) Inventor: BEGG, Lester, L., San Diego, CA 92130 (US)
(74) Representative: HOFFMANN - EITLE
(86) International application number: PCT/US2000/019031
(87) International publication number: WO 2001/004370

(56) References cited:
- US-A- 4 138 512
- US-A- 4 867 061
- US-A- 5 440 995
- EDITED BY ANDREW CROWSON AND EDWARD S. CHEN: "Tungsten and Tungsten Alloys- Recent Advances" 1991 , THE MINERALS, METALS & MATERIALS SOCIETY , USA XP002215753 * page 121 - page 128 *

## Description

This application claims priority from U.S. Serial No. 60/143,827, filed July 13, 1999.

There may be environmental and occupational hazards associated with the manufacture, deployment and use of depleted uranium (DU) as a ballistic penetrator. It would be desirable to have an alternative, benign material having penetration characteristics at least about equal to DU.

When a penetrator interacts with armor, it generates an aerosol and particles which are respirable and which may reach the gas exchange region of the human lung. In addition, penetrator impact fragments are deposited into the soil and can eventually find their way into the human food chain. DU is known to be toxic to the kidney, and it is also theoretically carcinogenic because of its residual radioactivity. Known tungsten heavy alloys, besides being inferior in penetration performance versus DU, contain nickel and cobalt alloying constituents that are also known to be toxic.

As a result of the foregoing, the testing of munitions with DU penetrators is limited to a few testing ranges within the U.S., and essentially, warfighters cannot train with the actual ammunition they will use in wartime because of the severe restrictions placed on training exercises at even these limited testing ranges in the U.S. After DU munitions are used in war (e.g. Desert Storm), a subsequent cleanup effort should be conducted to recover DU from the soil and prevent it from entering a food chain. Stored DU ammunition must be continuously inspected and accounted for during peacetime, introducing a non-productive accountancy requirement to the U.S. logistics chain.

Attempts have heretofore been made to develop polycrystalline tungsten-based composites and tungsten heavy alloys as replacements for DU. Despite developments that led to some increases in strength and toughness, the basic penetration performance of these materials did not significantly improve and did not approach that of DU. These studies demonstrated that penetration performance is not solely a function of strength or ductility.

After much research, it is now believed that material flow and failure mechanisms, not strength and ductility, are key properties in determining penetration performance. As a penetrator strikes armor, a high deformation rate in the penetrator causes heat to be generated. Because there is not enough time to conduct/diffuse this heat away from the deformation area, thermal softening occurs which overcomes the effect of previous hardening mechanisms, such as strain hardening. As a result, gross penetrator deformation occurs in locally softer material, along adiabatic shear bands, and the rapid failure along these adiabatic shear bands allows the penetrator to rapidly shed excess material. This rapid, localized deformation allows material to slough off and thus maintains a small diameter at the penetrator/armor interface. Without such localized shearing, the penetrator would form a large-diameter, blunt-nosed head that is much less effective. For a given value of kinetic energy, the small diameter penetrator will need to move less armor material, and will penetrate farther, than a larger, blunt-nosed penetrator.

The deformation behavior of DU follows the adiabatic shear band phenomenon described above, and the self-sharpening DU penetrator produces a small diameter hole in the armor. Single crystal unalloyed tungsten is also found to exhibit local deformation behavior, along crystalline planes, similar to that of DU. Single crystal unalloyed tungsten, when its [100] axis is parallel to the direction of travel, exhibits penetration capabilities equal to that of DU. Performance in other crystalline orientations, such as [111] or [110], is inferior to the [100] orientation. However, single crystal unalloyed tungsten has a high muzzle-launch failure rate; it appears to lack sufficient strength and ductility to reliably remain intact after launching.

A penetrator constituted of a single-crystal heavy-metal, such as tungsten or a tungsten alloy, possessing a strength and ductility varying along its length is described in US 4,867,061. US 5,440,995 discloses a tungsten penetrator with enhanced ability and strength employing tungsten whiskers which are hair-like crystals of a diameter of about 0.025 mm that are coated with metal and then sintered to create a matrix, which unites the extremely thin whiskers into a unified body.

The following criteria have now been developed by U.S. Army TACOM-ARDEC for screening candidate penetrator materials. If a candidate material meets and/or exceeds these screening criteria, it is felt that there is a high assurance that the material will survive muzzle launch. These screening criteria are:
Ultimate Tensile Strength ≥ 1240 MPa (180 ksi);
Tensile Yield Strength ≥ 690 Mpa (100 ksi); and
Elongation ≥ 12%.

It is an object of the present invention to provide high density penetrators that will meet the foregoing criteria and to provide methods for efficiently and economically fabricating such penetrators.

### Summary of the Invention

Certain high creep strength, single crystal tungsten alloys have now been developed which have increased strength and ductility compared to that of unalloyed single crystal tungsten. Tensile tests of one such single crystal tungsten alloy produced the following results:
Ultimate Tensile Strength ≥ 1380 MPa (200 ksi);
Tensile Yield Strength ≥ 690 MPa (100 ksi); and
Elongation ≥ 20%.
Such single crystal tungsten alloys are considered to have sufficient strength and ductility to survive muzzle launch. These high tungsten alloys contain at least about 90% tungsten, generally between about 90% and about 97%. Alloyed with the tungsten is tantalum, rhenium, niobium, molybdenum or a mixture of two or more of these metals.

Also provided are methods for economically and efficiently producing such high density penetrators using CVD. By using an appropriate single crystal substrate and CVD, it has been found that a single crystal body suitable for use as a high density penetrator can be fabricated from such an alloy of choice. In addition, a generally closed CVD system is also provided which makes very efficient use of raw materials and minimizes the creation of reaction byproducts that would otherwise require processing and/or other clean-up treatment prior to being discarded.

In one particular aspect, the invention provides a high density penetrator designed to be propelled from the muzzle of a weapon, which penetrator is generally circular in cross-section, has a length to diameter ratio of at least about 5 to 1 and comprises a shaped single-crystal alloy body having a diameter of at least 3 mm, comprising at least 90% tungsten with any remainder being tantalum, rhenium, niobium, molybdenum or a mixture thereof, said single-crystal body being aligned along the whole length with [100] orientation with respect to its long axis and being encased in a metal or metal alloy material, which has a ductility and strength greater than the ductility of said single-crystal alloy, said encasing material surrounding a head end portion of said single-crystal body and at least substantially the entire length thereof.

In another particular aspect, the invention provides a method for making a single crystal, high density alloy body containing a major amount of tungsten and a minor amount of tantalum, rhenium, niobium and/or molybdenum as an alloying metal, which body is suitable for use as a high density penetrator, said method comprising providing a chamber suitable for carrying out chemical vapor deposition (CVD), locating a single crystal substrate which is stable at a temperature of at least about 800°C within said chamber, introducing (a) tungsten chloride or fluoride vapor or (b) a vapor mixture of chlorides or fluorides of tungsten and said alloying metal into said CVD chamber, with the optional inclusion of H₂, and heating said single crystal substrate to at least about 800° so as to cause a single crystal tungsten alloy body of desired composition to grow upon the exterior surface of said single crystal substrate and create a high-density tungsten alloy body suitable for use as a penetrator.

### Brief Description of the Drawings

FIGS. 1, 2 and 3 are sectional views of high density penetrators embodying various features of the invention.
FIG. 4 is a schematic view showing the formation of a high density penetrator using CVD; and
FIG. 5 is a view similar to FIG. 4 showing an alternative CVD process embodying various features of the invention.

### Detailed Description of the Preferred Embodiment

As indicated above, it has been found that bodies of single crystal material can be formed of tungsten alloys which will have characteristics which meet the desired criteria set down by the United States Army for high density penetrators that will survive muzzle launch from a weapon. These single crystal materials should contain at least about 90% tungsten, e.g. about 90 to about 97%, preferably contain between about 91% and about 95% tungsten and more preferably contain between about 92% and about 94% tungsten, with one preferred alloy containing about 93% tungsten. Tungsten has a body-centered cubic crystalline structure, and the alloying elements should either have a body-centered cubic crystal structure or a hexagonal close packed crystal structure. The remainder of the alloy preferably contains tantalum, rhenium, niobium, molybdenum or a mixture of two or more of such metals. Although minor amounts of other elements having such a crystal structure can be tolerated, such presence should be minimized so as not to detract from the desired high density of the body. Of the candidates for alloying elements, rhenium has a particularly high density, and tantalum alloys exhibit particularly high strength. Accordingly, tantalum and rhenium are considered to be preferred. The single crystal body should have a density of at least about 98% of maximum theoretical density of the alloy. As an example, one preferred alloy contains about 93% tungsten and about 7% tantalum.

The penetrators may have various shapes so long as they are suitable for being propelled from the muzzle of a weapon, e.g. canons, machine guns and the like. They will normally have a fairly high length to diameter ratio, and they will usually have either an aerodynamically-shaped head or be embodied within a mass that has such a aerodynamically-shaped head as described hereinafter.

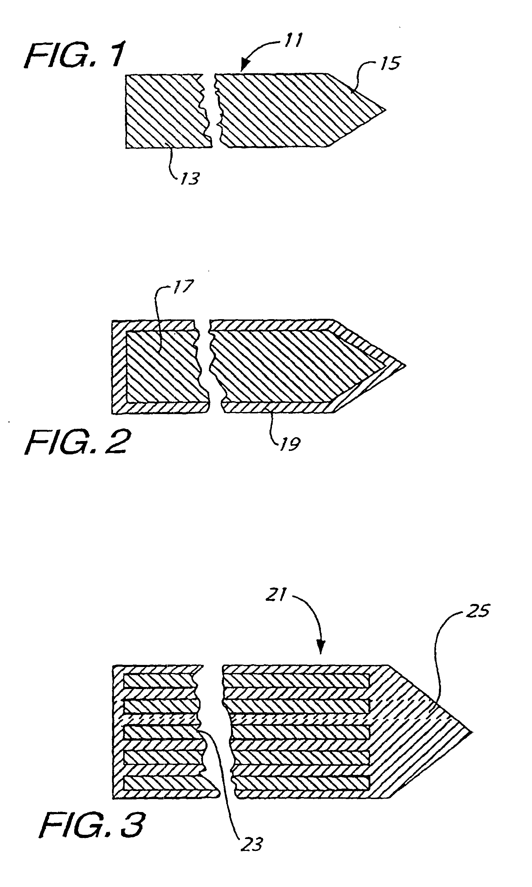

FIG. 1 shows a single penetrator or projectile 11 that is made of substantially homogenous material which is a single crystal tungsten alloy, e.g. 93% W and about 7% Ta. The penetrator 11 has a cylindrical main body 13 and a generally conical head 15. It should have a length/diameter ratio of at least about 5 to 1, preferably at least about 10 to 1 and more preferably at least about 15 to 1. For example, a penetrator of a larger class may be formed of single crystal material having a diameter of about 1 inch and a length from about 356 mm to 640 mm (about 14 to 24 inches). Smaller size penetrators may have, for example, a diameter of 8.31 mm and a length of 96.4 mm or a diameter of 12.68 mm and a length of 70.5 mm. The single crystal tungsten alloy is formed such that the body-centered cubic crystalline structure is oriented so that the [100] crystalline axis is parallel to the axis of the penetrator 11. Such projectiles are capable of penetrating the armor of tanks and/or personnel carriers.

It has been found that, in some instances, it may be desirable (see FIG. 2) to encase a single-crystal body 17 in an exterior shell or sheath 19 of a fairly similar dense alloy that has strength and ductility higher than that of the single crystalline body to create an effective penetrator. Examples of suitable materials are those which contain at least about 90% tungsten and various amounts of nickel, iron and/or cobalt. One that is referred to as WHA contains 93% W, 4.9% Ni and 2.1% Fe; another contains 97.1% W, 1.4% Ni, 0.7% Fe and 0.8% Co. If, for example, it were desired for such a penetrator to have a diameter of about 1 inch, the thickness of the encasing, stronger, more ductile, dense material might be about (2.5 mm) (0.1 inch). As illustrated in FIG. 2, the encasing sheath 19 could completely cover the single crystal body 17 or, if desired, the encasing material could be omitted at the flat tail end of the penetrator.

A further alternative example of a penetrator 21 is shown in FIG. 3 wherein a plurality of uniformly spaced apart-rods 23 of single crystal tungsten alloy material are embedded in a matrix 25 that is formed from such dense more ductile tungsten alloy, such as WHA which was discussed above. In such an instance, this plurality of single crystal rods 23 might be individually about 3 mm to about 6 mm (about 1/8 inch to 1/4 inch) in diameter, with the conical head end of the penetrator 21 being formed of WHA or the like. For example, a penetrator 21 of this style might include 44 single crystal, high density, tungsten alloy rods, each about 6.35 mm (about ¼ inch) in diameter and 584 mm (23 inches) in length, uniformly spaced within a cylindrical body of WHA having a diameter of about 25.1 mm (about 1 inch). Such an arrangement may have fabrication advantages particularly when the high density single crystal tungsten alloy rods are being grown from fine wire cores.

The single crystal body can be formed using a zone-refining process, as known in this art, in which an electron beam filament carefully locally heats a rod to cause localized melting and then recrystallization. A single crystal seed is located at the bottom of a polycrystalline rod of the desired alloy composition. The electron beam filament initially heats and melts the bottom of the polycrystalline rod where there is contact with the single crystal seed which is oriented with its [100] axis aligned with the long axis of the rod that will constitute the penetrator. The single crystal structure of the seed and its orientation spreads into the molten zone, transforming that portion of the now melted polycrystalline rod into conforming single crystal material. The filament slowly travels up the length of the rod, producing a local molten zone as it travels. This enables the single crystal structure to spread upward, the molten zone transforming the former polycrystalline crystallography into a single crystal having the desired axial orientation. The resultant single crystal material can then be shaped by grinding or other machining operations so as to have the desired penetrator shape, e.g. a solid cylinder having an external head end taper as shown in FIG. 1, plus desired grooves and/or threads and the like.

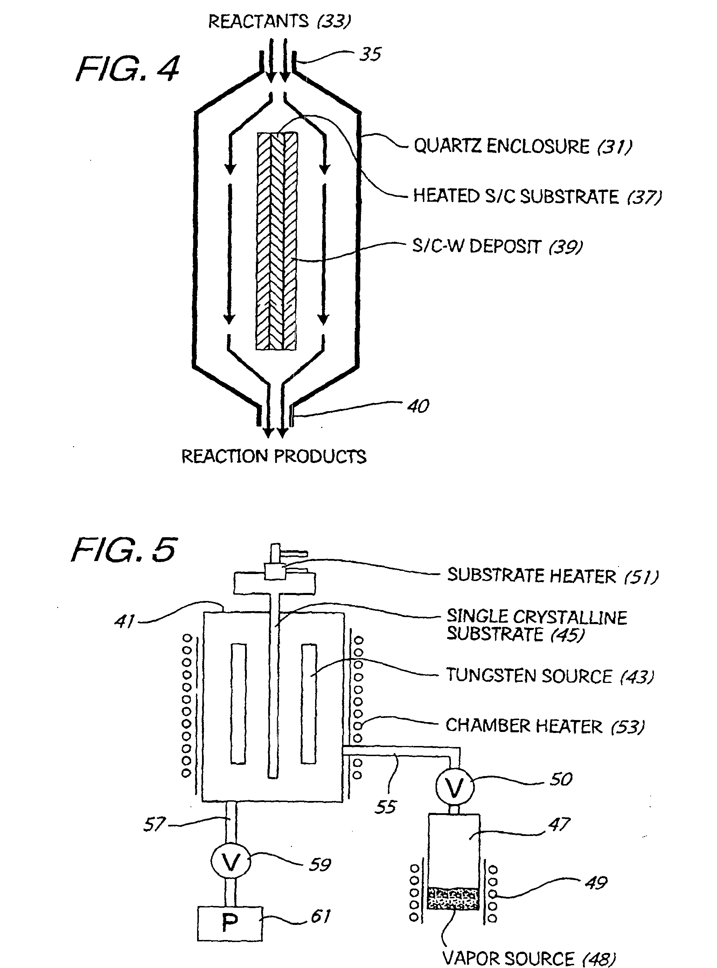

It has been found that high density single crystal material having a desired crystalline axial orientation can also be formed using conventional chemical vapor deposition(CVD) methods. As depicted schematically in FIG. 4, a vaporous (gaseous) mixture of WF₆/TaF₅/H₂ or WCl₆/TaCl₅ can be caused to flow over a heated, single-crystal mandrel having a body centered cubic crystalline structure (Mo for example), and an alloy of tungsten and tantalum can be deposited which will adopt the single crystal structure and the crystalline axial orientation of the mandrel/substrate.

Using a standard quartz chamber or enclosure 31, an alloy is deposited from a mixture 33, for example, having the appropriate proportions of tungsten fluoride, tantalum fluoride and hydrogen, which may be supplied through an upper entrance 35. By heating a fine wire or thin rod being used as a substrate 37, a single crystal body 39 is formed at a substrate temperature of at least about 800 to 900°C under otherwise standard CVD operating conditions, i.e. flowing the gaseous mixture downward through the coating chamber 31 under reasonably high vacuum conditions (e.g. about 1-20 torr) and at a rate of about 1.5 µm to about 25 µm per minute. Higher temperatures can be employed and may be preferred depending upon the diameter of the final product that is desired as explained hereinafter. The desired single crystal material grows uniformly radially outward about the surface of the molybdenum wire substrate. Although other body-centered cubic crystalline materials can be used as the substrate 37, single crystal molybdenum is fairly readily available and is preferred for this reason.

If instead a mixture of tungsten and tantalum chlorides is used together with a higher temperature of about 1200 to about 1300°C and otherwise standard CVD conditions, the desired alloy will be readily deposited without the inclusion of hydrogen. Thus, the inclusion of hydrogen in the gaseous mixture is considered to be optional, and therefore only a minor amount or no hydrogen may be included. The unreacted chlorides and/or fluorides along with the HF or Cl₂ reaction products are removed from the opposite end 40 of the chamber wherein the coating takes place and must be appropriately reclaimed or disposed of. By appropriately selecting the substrate as a body-centered cubic crystal material with its [100] axis oriented longitudinally, the desired high density tungsten alloy body 39 having single crystal form and this desired crystalline orientation is obtained.

Both of the foregoing methods are fairly expensive to operate, and it has now been found that a single crystal tungsten alloy material can also be produced using what is being termed a static CVD system and is schematically shown in the accompanying FIG. 5. In this system, vaporous WF₆/H₂ or WCl₆ reactants are initially supplied to an otherwise closed reaction chamber 41. The illustrated system is adapted to deposit a tungsten alloy by positioning a solid feedstock 43 of polycrystalline elemental alloy material within the chamber, preferably in surrounding relationship to a centrally located single crystal substrate 45. Within this closed volume, a partial pressure of H₂ (optional) and, for example, either (a) WF₆ or WF₆ and TaF₅ or (b) WCl₆ or WCl₆ and TaCl₅ vapors are initially provided, as by heating a suitable reservoir 47 containing one or more such reactants 48 to about 80 to 200°C by employing a suitable heater and optionally adding H₂ (not shown) to the stream which is fed through a valve 50. As previously mentioned, when tungsten chloride is employed, it should not be necessary to add hydrogen although the presence of hydrogen is not felt to detract at all from such CVD. Moreover, it may not be necessary to include a minor amount of the halide of the alloying metal in the vaporous atmosphere that is initially supplied, as this small amount of vapor will account for only a very minor deposition onto the surface of the heated substrate 45, creating a Cl₂ atmosphere that then reacts with the polycrystalline alloy feedstock 43 to thereafter create the desired vaporous alloy composition within the closed chamber 41.

As seen in FIG. 5, the chamber 41 is vertically oriented and designed to have a substrate heater 51 positioned axially above the chamber which would heat, as by resistance heating, a thin wire or rod 45 of molybdenum located centrally, i.e. coaxially, within the chamber. The substrate 45 may have a diameter of about 0.25 mm (0.01 inch) to about 0.8 mm (0.032 inch). Surrounding the substrate 45 upon which the deposition will occur is solid feedstock 43 which may be in the form of a tube of the desired alloy composition or a plurality of individual rods oriented in a circular array about the central substrate. The substrate heater 51 will heat the single crystal substrate 45 to a high temperature as described above, e.g. 900°C to about 1100°C where chlorides are being used. The chamber 41 might be surrounded by a usual resistance or induction heater 53 which might be designed and operated to heat the chamber walls to about 150°C while heating the feedstock material 43 to a temperature which will generally be at least about 100°C lower, and preferably at least about 150°C lower than that of the substrate, e.g. feedstock temperatures may be about 700°C to 900°C. However, higher substrate temperatures may be desirable for reasons set forth hereinafter.

A side entrance 55 is provided in order to initially supply the chamber 41 with the desired gaseous atmosphere. Moreover, an exit conduit 57 is also provided connected via a valve 59 to a pump 61 for evacuating the chamber. Both of these conduits have standard shut-off valves 50, 59.

As an example of operation, the single crystal substrate 45, e.g. Mo wire, and the feedstock 43, e.g. W-Ta alloy, are placed within the chamber 41 and the valve 50 closed. Then, the valve 59 leading to the evacuation pump 61 is opened, and the pump operated to evacuate the chamber to an atmospheric pressure of about 1 torr. Once this low pressure is achieved, the valve 59 is closed, and the valve 50 is opened allowing tungsten chloride vapor to flow into the reaction chamber from the heated source, which might be at a temperature between about 80°C and about 130°C so that the solid material will have a vapor pressure of about 20 torr. As previously mentioned, a minor amount of hydrogen could be optionally supplied along with the tungsten chloride. When the pressure within the coating chamber reaches about 3-20 torr, the valve 50 is closed, and the heaters 51 and 53 are operated to begin the CVD. As the single crystal mandrel 45, e.g. a thin wire of single crystal Mo, and the polycrystalline tungsten and tantalum feedstock 43 are brought up to operating temperatures, metal alloy from the vaporous chlorides begins depositing causing the single crystal wire to grow radially outward and creating gaseous Cl₂. The feedstock 43 is heated to an appropriate slightly lower temperature at which a reaction with the metal alloy will occur to form vaporous metal chlorides. RF or resistance heating may be used for either or both heating tasks. For example, the temperature of a polycrystalline W/Ta feedstock alloy may be suitably controlled to provide the desired vaporous atmosphere from which a high density, single crystal body is deposited at the higher temperature of the substrate. WCl₆ and TaCl₅ react at the heated substrate, depositing W and Ta having the desired alloy composition and yielding Cl₂. The Cl₂ diffuses radially outward from the mandrel and travels to the lower temperature polycrystalline tungsten/tantalum feedstock 43, where it reacts, producing WCl₆ and TaCl₅.

The operation is allowed to simply continue until the desired diameter single crystal alloy body has been produced. However, to avoid the potential build-up of contamination within the chamber 41 as a result of the possible presence of minute amounts of contaminants within the feedstock material, it may be desired to periodically evacuate the chamber to remove any such contaminants. This can be simply done by momentarily opening the isolation valve 59 and starting the pump 61 to effect such evacuation; thereafter, that valve 59 is closed and the valve 50 to the vapor source 48 is momentarily again opened to replenish the atmosphere as it was initially supplied to start the CVD process. Such evacuation and replenishment might be carried out at any suitable intervals, dependent upon the likelihood of contamination within the feedstock material, e.g. every 30 minutes or 1 hour.

It has been found that, as the diameter of the resultant body being caused to radially grow through CVD substantially exceeds the diameter of the original single crystal wire or rod that serves as the substrate, there is a tendency for the axial orientation of the newly deposited crystalline material to vary. Generally, this is not a problem until the ratio of the diameter of the single crystal body to the diameter of the original substrate exceeds about 3 or 4 to 1. Because this may oftentimes be the situation, attention has been given to it, and it has been found that carrying out the CVD at a higher temperature, for example about 1600 to about 2200°C, has the effect of annealing out strains that may be induced by such alternative crystalline orientation and assures the growth of the single crystal body having the desired orientation. Accordingly, it may be desirable to employ temperatures in the higher portion of the range of about 800°C to about 2200°C whenever the diameter of the desired resultant product will be more than about five times that of the substrate, in order to assure a uniform resultant product. Even when such higher substrate temperatures are employed, the feedstock temperature is preferably in the range of about 700° to about 900°C.

Once a single crystal body of the desired diameter has been achieved, the equipment is shut down and allowed to slowly cool to ambient temperature. Removal of the body from the chamber 41 and examination shows that it has indeed achieved single crystal structure with the crystalline [100] axis aligned longitudinally of the cylindrical body. Measurement also shows that it is fully dense, having achieved essentially 100% of theoretical maximum density for a body made of 93% tungsten and 7% tantalum, with a minute central molybdenum core.

Using this static CVD method, the cost to produce such bodies of high density, single-crystal, tungsten alloys particularly suited for use as high-density penetrators is reduced significantly over either the traditional zone-refining method or the standard CVD method. When employing the standard CVD process, for example, a certain proportion of the metal chlorides or metal fluorides will not react and will be carried out of the reactor as a part of the exhaust system, which then must either be treated to reclaim these reactants or appropriately disposed of. Likewise, there are essentially toxic HF, HCl and/or Cl₂ vapors that exit the reactor that must be handled in an environmentally acceptable manner. It can thus be seen that all this adds to the cost of operation of the standard CVD process whereas, in the static CVD system illustrated in FIG. 5, operation is essentially that of a controlled closed system, and the only waste materials are those which result from the momentary evacuations that are carried out.

In certain instances, it may be desirable to have the penetrator include some pyrophoric material, i.e. a pyrophor, which will oxidize and create smoke or fumes that will be indicative that a particular target has indeed been penetrated by breaching its armor, thereby allowing focus to be shifted to another potential target. Suitable pyrophoric materials for this purpose include hafnium, titanium and zirconium. In the case of an otherwise homogenous penetrator, it might be suitable to simply drill out the original molybdenum core and then fill this core with a suitable pyrophor, e.g. hafnium. On the other hand, if a multiple rod penetrator, such as that depicted in FIG. 3, is employed, one or more small rods of hafnium or another pyrophor could be included or discrete particles of a pyrophor might be included as a part of the matrix WHA material used to combine the plurality of single crystal tungsten alloy rods into such a composite penetrator 21.

Although the invention has been described with regard to certain preferred embodiments which constitute the best mode presently known to the inventor, it should be understood that various changes and modifications as would be obvious to one having the ordinary skill in this art, may be made without departing from the invention which is defined by the claims appended hereto. For example, although the discussion of the fabrication processes mention using a feedstock of 93% tungsten and 7% tantalum, all or a part of the tantalum might be substituted by rhenium, and rhenium chloride (ReCl₄ or ReCl₆) in a minor amount might be included with the vaporous WCl₆ that is supplied to the chamber. Likewise, in a conventional CVD process, a mixture of hydrogen, tungsten fluoride and rhenium fluorides might be used, or alternatively all or some of the alloying metal could be supplied by niobium fluoride, while still creating a single crystal tungsten alloy penetrator having its [100] axis oriented in the desired direction.

## Claims

1. A high density penetrator designed to be propelled from the muzzle of a weapon, which penetrator is generally circular in cross-section, has a length to diameter ratio of at least about 5 to 1 and comprises a shaped single-crystal alloy body having a diameter of at least 3 mm, comprising at least 90% tungsten with any remainder being tantalum, rhenium, niobium, molybdenum or a mixture thereof, said single-crystal body being aligned along the whole length with [100] orientation with respect to its long axis and being encased in a metal or metal alloy material, which has a ductility and strength greater than the ductility of said single-crystal alloy, said encasing material surrounding a head end portion of said single-crystal body and at least substantially the entire length thereof.

2. The penetrator according to claim 1 wherein said single-crystal alloy contains at least about 93% tungsten and at least a major portion of the remainder of said single-crystal alloy is tantalum or rhenium and wherein said single-crystal alloy has a density of at least about 98% of the theoretical density of said single-crystal material.

3. The penetrator according to claim 1 wherein said body consists of a rod having a diameter of at least 8 mm and wherein said encasing material includes an aerodynamically-shaped head end.

4. The penetrator according to claim 1 wherein a plurality of said single-crystal bodies are embedded in parallel, spaced-apart orientation in said encasing more ductile and stronger material.

5. The penetrator according to any one of claims 1-4 wherein said encasing material is a metal alloy including a major portion of tungsten alloyed with minor portions of nickel, iron and cobalt and wherein said encasing material includes at least about 1% by weight of a pyrophoric metal selected from the group consisting of hafnium, zirconium, titanium and mixtures thereof.

6. A method for making a single-crystal, high density alloy body containing a major amount of tungsten and a minor amount of tantalum, rhenium, niobium and/or molybdenum as an alloying metal, which body is suitable for use as a high density penetrator, said method comprising
providing a chamber suitable for carrying out chemical vapor deposition (CVD),
locating a stable single-crystal substrate within said chamber,
providing a vapor mixture of chlorides or fluorides of tungsten and said alloying metal in said CVD chamber, with the optional inclusion of H₂, and
heating said single-crystal substrate to a temperature so as to cause a single-crystal tungsten alloy body of desired composition to grow upon the exterior surface of said single-crystal substrate and create a high-density tungsten alloy body suitable for use as a penetrator.

7. A method according to claim 6 wherein said chamber can be periodically closed to outlet flow therefrom, said vapor mixture is provided by providing a solid feedstock in the form of a major amount of elemental tungsten and a minor amount of said elemental alloying metal in said CVD chamber by heating said solid feedstock to a temperature of at least about 700°C but below that of said substrate, and initially introducing vapor into said chamber containing chlorine or fluorine and then discontinuing vapor flow into or out of said chamber to cause the deposition of a single-crystal alloy of elemental tungsten and said alloying metal upon said substrate with the simultaneous creation of Cl₂ or F₂ vapor which reacts with said heated solid feedstock to form metal halide vapors that then react at said substrate.

8. The method according to claim 7 wherein said chamber is periodically evacuated and the atmosphere of said evacuated chamber is resupplied with said vapor initially introduced.

9. The method according to either claim 7 or 8 wherein said vapor contains chlorine, wherein said single-crystal substrate and said growing single-crystal alloy body are heated to a temperature between about 1600°C and about 2200°C, and wherein said feedstock is heated to a temperature which is not above about 900°C.

10. The method according to either claim 7 or 8 wherein said vapor contains tungsten fluoride and hydrogen, causing the deposition of elemental tungsten and said alloying metal upon said substrate with the simultaneous creation of HF, which HF subsequently reacts with said heated solid feedstock to form additional metal vapors.

11. The method according to any one of claims 6-8 wherein said substrate is a thin wire which is aligned with the [100] orientation with respect to its long axis.

12. The method according to claim 11 wherein said single-crystal substrate is formed of a metal or an alloy of metals having a body-centered cubic crystal structure and wherein said heating is continued until said single-crystal body has grown to have a diameter of at least about 3 mm.

## Patentansprüche

1. Hochdichter Penetrator, der dafür geschaffen ist, aus der Mündung einer Waffe getrieben zu werden, wobei der Penetrator im Querschnitt allgemein kreisförmig ist, ein Längen-zu-Durchmesser-Verhältnis von mindestens etwa 5 bis 1 hat und einen geformten Einkristall-Legierungskörper mit einem Durchmesser von mindestens 3 mm umfasst, der mindestens 90 % Wolfram umfasst, wobei jeglicher Rest Tantal, Rhenium, Niob, Molybdän oder eine Mischung davon ist, wobei der Einkristall-Körper entlang der gesamten Länge in [100]-Orientierung in bezug auf seine lange Achse ausgerichtet und in einem Metall- oder Metallegierungsmaterial eingeschlossen ist, das eine Duktilität und Festigkeit besitzt, die grösser ist als die Duktilität der Einkristall-Legierung, wobei das umhüllende Material einen Teil des Kopfendes des Einkristall-Körpers und mindestens im wesentlichen die gesamte Länge davon umschliesst.

2. Penetrator gemäss Anspruch 1, worin die Einkristall-Legierung mindestens etwa 93 % Wolfram enthält und mindestens ein Hauptanteil des Restes der Einkristall-Legierung Tantal oder Rhenium ist und worin die Einkristall-Legierung eine Dichte von mindestens etwa 98 % der theoretischen Dichte des Einkristall-Materials besitzt.

3. Penetrator gemäss Anspruch 1, worin der Körper aus einem Stab mit einem Durchmesser von mindestens 8 mm besteht und worin das umhüllende Material ein aerodynamisch geformtes Kopfende einschliesst.

4. Penetrator gemäss Anspruch 1, worin eine Mehrzahl der Einkristall-Körper in paralleler getrennter Orientierung in der Umhüllung aus duktilerem und festerem Material eingebettet ist.

5. Penetrator gemäss irgendeinem der Ansprüche 1 bis 4, worin das umhüllende Material eine Metallegierung ist, die einen Hauptanteil an Wolfram, legiert mit geringen Anteilen an Nickel, Eisen und Kobalt, einschliesst und worin das umhüllende Material mindestens etwa 1 Gew.% eines pyrophoren Metalls einschliesst, das aus der Gruppe ausgewählt ist, die aus Hafnium, Zirkonium, Titan und Mischungen daraus besteht.

6. Verfahren zur Herstellung eines Einkristall-Legierungskörpers hoher Dichte, der eine Hauptmenge an Wolfram und eine geringe Menge an Tantal, Rhenium, Niob und/oder Molybdän als Legierungsmetall enthält, wobei der Körper zur Verwendung als hochdichter Penetrator geeignet ist, und wobei das Verfahren umfasst:
Bereitstellen einer Kammer, die sich für die Durchführung einer chemischen Dampfabscheidung (CVD) eignet,
Anordnen eines stabilen Einkristall-Substrats in der Kammer,
Bereitstellen einer Gasmischung aus Chloriden oder Fluoriden von Wolfram und dem Legierungsmetall in der CVD-Kammer, mit dem optionalen Einschluss von H₂, und
Aufheizen des Einkristall-Substrats auf eine Temperatur, um das Wachstum eines Einkristall-Wolframlegierungskörpers gewünschter Zusammensetzung auf der äusseren Oberfläche des Einkristall-Substrats zu bewirken und einen hochdichten Wolframlegierungskörper zu schaffen, der sich zur Verwendung als Penetrator eignet.

7. Verfahren gemäss Anspruch 6, worin die Kammer periodisch geschlossen werden.kann, um Ausfluss herauszulassen, die Gasmischung bereitgestellt wird durch Bereitstellen eines festen Ausgangsmaterials in Form einer Hauptmenge an elementarem Wolfram und einer geringen Menge des elementaren Legierungsmaterials in der CVD-Kammer durch Erhitzen des festen Ausgangsmaterials auf eine Temperatur von mindestens etwa 700°C, aber unterhalb der des Substrats, und anfängliches Einführen von Dampf in die Kammer, der Chlor oder Fluor enthält, und dann Unterbrechen des Dampfstroms in oder aus der Kammer, um die Abscheidung einer Einkristall-Legierung aus elementarem Wolfram und dem Legierungsmetall auf dem Substrat bei gleichzeitiger Bildung von Cl₂- oder F₂-Dampf zu bewirken, der mit dem erhitzten festen Ausgangsmaterial unter Bildung von Metallhalogeniddämpfen reagiert, die dann mit dem Substrat reagieren.

8. Verfahren gemäss Anspruch 7, worin die Kammer periodisch evakuiert wird und die Atmosphäre der evakuierten Kammer wieder mit dem anfänglich eingeführten Dampf versorgt wird.

9. Verfahren gemäss Anspruch 7 oder 8, worin der Dampf Chlor enthält, worin das Einkristall-Substrat und der wachsende Einkristall-Legierungskörper auf eine Temperatur zwischen etwa 1.600 und etwa 2.200°C erhitzt werden, und worin das Ausgangsmaterial auf eine Temperatur erhitzt wird, die nicht oberhalb von etwa 900°C liegt.

10. Verfahren gemäss Anspruch 7 oder 8, worin der Dampf Wolframfluorid und Wasserstoff enthält, was die Abscheidung von elementarem Wolfram und dem Legierungsmetall auf dem Substrat unter gleichzeitiger Bildung von HF bewirkt, wobei HF anschliessend mit dem erhitzten festen Ausgangsmaterial unter Bildung von zusätzlichen Metalldämpfen reagiert.

11. Verfahren gemäss irgendeinem der Ansprüche 6 bis 8, worin das Substrat ein dünner Draht ist, der in der [100]-Orientierung in bezug auf seine lange Achse ausgerichtet ist.

12. Verfahren gemäss Anspruch 11, worin das Einkristall-Substrat aus einem Metall oder einer Legierung von Metallen gebildet wird, die eine kubisch raumzentrierte Kristallstruktur haben, und worin das Erhitzen fortgeführt wird, bis der Einkristall-Körper auf einen Durchmesser von mindestens etwa 3 mm gewachsen ist.

## Revendications

1. Pénétrateur à haute densité conçu pour être propulsé depuis la bouche d'une arme, lequel pénétrateur est de section transversale globalement circulaire, a un rapport de la longueur au diamètre d'au moins environ 5 à 1 et comporte un corps en alliage monocristallin façonné ayant un diamètre d'au moins 3 mm, comprenant au moins 90 % de tungstène avec toute partie restante quelconque constituée de tantale, de rhénium, de niobium, de molybdène ou d'un mélange de ceux-ci, ledit corps monocristallin étant aligné sur toute la longueur avec une orientation [100] par rapport à son axe long et étant enveloppé dans une matière formée d'un métal ou d'un alliage métallique, qui a une ductilité et une résistance supérieures à la ductilité dudit alliage monocristallin, ladite matière enveloppante entourant une partie extrême de tête dudit corps monocristallin et au moins sensiblement toute sa longueur.

2. Pénétrateur selon la revendication 1, dans lequel ledit alliage monocristallin contient au moins environ 93 % de tungstène et au moins une partie majeure de la portion restante dudit alliage monocristallin est du tantale ou du rhénium, et dans lequel ledit alliage monocristallin a une densité d'au moins environ 98 % de la densité théorique de ladite matière monocristalline.

3. Pénétrateur selon la revendication 1, dans lequel ledit corps consiste en une tige ayant un diamètre d'au moins 8 mm et dans lequel ladite matière enveloppante comprend une extrémité de tête de forme aérodynamique.

4. Pénétrateur selon la revendication 1, dans lequel plusieurs desdits corps microcristallins sont encastrés dans une orientation parallèle et espacés dans ladite matière d'enveloppe plus ductile et résistante.

5. Pénétrateur selon l'une quelconque des revendications 1 à 4, dans lequel ladite matière d'enveloppe est un alliage métallique comprenant une partie majeure en tungstène alliée avec des parties mineures en nickel, en fer et en cobalt, et dans lequel ladite matière enveloppante comprend au moins environ 1 % en poids d'un métal pyrophorique choisi dans le groupe consistant en l'hafnium, le zirconium, le titane et des mélanges de ceux-ci.

6. Procédé pour réaliser un corps en alliage monocristallin à haute densité contenant une quantité majeure de tungstène et une quantité mineure de tantale, de rhénium, de niobium et/ou de molybdène en tant que métal d'alliage, lequel corps convient à une utilisation en tant que pénétrateur à haute densité, ledit procédé comprenant
l'utilisation d'une chambre apte à l'exécution d'un dépôt chimique en phase vapeur (CVD),
la mise en place d'un substrat monocristallin stable à l'intérieur de ladite chambre,
l'utilisation d'un mélange à l'état de vapeur, de chlorures ou de fluorures de tungstène et dudit métal d'alliage dans ladite chambre à dépôt CVD, avec l'inclusion facultative de H₂, et
le chauffage dudit substrat monocristallin à une température amenant un corps en alliage de tungstène monocristallin d'une composition souhaitée à croître sur la surface extérieure dudit substrat monocristallin et à créer un corps en alliage de tungstène à haute densité apte à une utilisation en tant que pénétrateur.

7. Procédé selon la revendication 6, dans lequel ladite chambre peut être fermée périodiquement afin d'en empêcher tout écoulement de sortie, ledit mélange à l'état de vapeur est produit en utilisant une matière de charge solide sous la forme d'une quantité majeure de tungstène élémentaire et d'une quantité mineure dudit métal d'alliage élémentaire dans ladite chambre de dépôt CVD par chauffage de ladite matière de charge solide à une température d'au moins environ 700°C, mais inférieure à celle dudit substrat, et par l'introduction initiale d'une vapeur dans ladite chambre contenant du chlore ou du fluor, puis par interruption de l'écoulement de vapeur en entrée ou en sortie de ladite chambre pour provoquer le dépôt d'un alliage monocristallin de tungstène élémentaire et dudit métal d'alliage sur ledit substrat avec la création simultanée d'une vapeur de Cl₂ ou de F₂ qui réagit avec ladite matière de charge solide chauffée pour former des vapeurs d'halogénures métalliques qui réagissent ensuite au niveau dudit substrat.

8. Procédé selon la revendication 7, dans lequel ladite chambre est vidée périodiquement et l'atmosphère de ladite chambre vidée est réalimentée en ladite vapeur introduite initialement.

9. Procédé selon la revendication 7 ou 8, dans lequel ladite vapeur contient du chlore, dans lequel ledit substrat monocristallin et ledit corps en alliage monocristallin croissant sont chauffés à une température comprise entre environ 1600°C et environ 2200°C, et dans lequel ladite matière de charge est chauffée à une température qui n'est pas supérieure à environ 900°C.

10. Procédé selon la revendication 7 ou 8, dans lequel ladite vapeur contient du fluorure de tungstène et de l'hydrogène, provoquant le dépôt de tungstène élémentaire et dudit métal d'alliage sur ledit substrat avec la création simultanée de HF, lequel HF réagit ensuite avec ladite matière de charge solide chauffée pour former des vapeurs métalliques supplémentaires.

11. Procédé selon l'une quelconque des revendications 6 à 8, dans lequel ledit substrat est un fil mince qui est aligné avec l'orientation [100] par rapport à son axe long.

12. Procédé selon la revendication 11, dans lequel ledit substrat monocristallin est formé d'un métal ou d'un alliage de métaux ayant une structure cristalline cubique centrée, et dans lequel ledit chauffage est poursuivi jusqu'à ce que ledit corps monocristallin ait atteint par croissance un diamètre d'au moins environ 3 mm.
